# EUROPEAN PATENT SPECIFICATION

(11) **EP 0 448 826 B1**
(45) Date of publication and mention of the grant of the patent: **27.03.1996**
(21) Application number: 90125142.1
(22) Date of filing: 21.12.1990
(51) Int. Cl.: H03K 17/969, H03K 17/968

(54) **Keyboard**
Tastatur
Clavier

(30) Priority: 29.03.1990 FI 901585
(43) Date of publication of application: 02.10.1991
(73) Proprietor: NOKIA MOBILE PHONES LTD., SF-24101 Salo (FI)
(72) Inventor: Rossi, Markku, SF-25130 Muurla (FI)
(74) Representative: TER MEER - MÜLLER - STEINMEISTER & PARTNER

(56) References cited:
- EP-A- 0 274 725
- US-A- 3 340 401
- US-A- 3 758 785
- US-A- 4 049 964
- PATENT ABSTRACTS OF JAPAN, vol. 6, no. 46 (P-107)(924) 24 March 1982;& JP-A-56162135

## Description

The invention relates to a keyboard comprising at least one key mounted in connection with a circuit board including a light source, the key comprising a key cap and, between the key cap and the circuit board, a body part diffusively transmitting the light for illuminating the key, the light source being arranged to conduct light into the body part and to illuminate the key.

In prior art keys, the key body usually is a part manufactured of plastic by moulding, its bottom surface being coated with an electrically conducting material. The coating material must be elastic, and its resistance from one edge of the coated area to the other edge has to be between 100 and 100 ohms. Such a coating will considerably increase the cost of the otherwise cheap moulded plastic part, and thus it will increase the manufacturing costs of the keyboard.

When the key is depressed, the bottom surface of the body part will hit a contact area comprising two halves on the surface of the circuit board. These halves are also coated with an electrically conducting material. When the bottom surface of the key body part establishes a short circuit between the halves of the contact area, the depressing can be electronically detected. The addition of the contact halves' material decreases the yield of the circuit boards and increases their manufacturing costs. In particular, the aligning difficulties at either end of the keyboard will cause material losses. In addition, the electrical contact is exposed to humidity and chemical aging processes and to rubbish entering the operating device.

The illumination of the key is according to prior art realized so, that on the surface of the circuit board there are light emitting diodes (LED) illuminating the keyboard. The light is conducted from the LEDs through light conductors to the body part proper and the key. Generally one LED is illuminating several keys at the same time, e.g. so that 20 keys are illuminated by 6 LEDs. As a consequence, the luminance of the light will vary from key to key. In addition the luminance value will be low. In prior art it is very difficult to realize a light conductor network, which would evenly distribute the light to every key.

US-A-3 340 401 discloses a keyboard, each key including a light source and a photocell mounted in bores in a body part covered by a translucent cap which is illuminated by the light source. By contacting the upper surface of the cap by means of a finger, light transmitted through the cap is reflected and impings onto the photocell producing an output indicating depression actuation or touch of the key.

The aim of the invention is to produce a keyboard, which has low manufacturing costs and which functions independently of said humidity and other environmental effects. It is a further aim to produce a keyboard with individual keys evenly and sufficiently illuminated. These aims are achieved with a keyboard as defined in Claim 1. Thus, according to the invention, a photoelectric member is mounted on the circuit board under the key at a distance from the light source, and there is further arranged a light barrier in connection with the circuit board or with the key, the barrier being arranged to shield the photoelectric member from the light of the light source coming from the body part when the key is in its depressed position and to produce an electric change in the photoelectric member indicating a depression of the key.

An embodiment of the invention is further characterized in that the light source is placed on the circuit board under the key, and that a reflecting surface is arranged above the light source, between the key cap and the body part, reflecting light from the light source into the body part.

In a keyboard according to the invention no electrically conducting contact surfaces are required, but the depression of a key is detected through a signal generated by the photoelectric member. Thus the keyboard is functionally reliable, as humidity, dirt and oxidation will not affect the operation of the key. By using an own light source in every key the illumination of the keyboard is further increased, and at the same time the illumination will be equally strong in different parts of the keyboard.

The keyboard according to the invention is explained in more detail below, referring to the enclosed drawing, where
- figure 1: a shows in cross-section a keyboard key according to the invention in its upper position;
- figure 1b: shows the key of figure 1a in its depressed position;
- figure 2a: shows in cross-section another keyboard key according to the invention in its upper position; and
- figure 2b: shows the key of figure 2a in its depressed position.

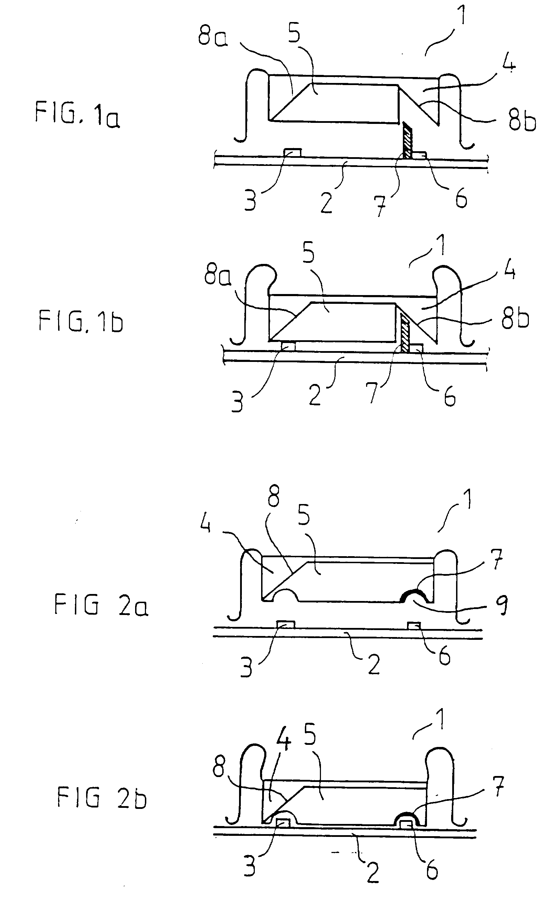

A keyboard key according to the invention is shown in figure 1. The keyboard comprising at least one such key 1 is mounted in connection with a circuit board 2. On the circuit board there is a light source 3, that can be common to several keys. Then the light from the light source 3 is conducted to every key, e.g. via a light conductor.

In the case of figure 1a an own light source is assigned to every key. As a light source it is possible to use a surface mounted light emitting diode (LED). The light source 3 is arranged to conduct the light into the body part 5 and to illuminate the key 1. The key 1 is illuminated, partly to make the symbol of the key clearly visible also in daylight.

The key 1 comprises a key cap 4 and between the key cap 4 and the circuit board 2 a body part 5 diffusively transmitting light from the light source 3.

The purpose of the key cap 4 is to cover the key 1. Generally the center of the key cap 4 is provided with a transparent spot, through which the illuminated body part 5 and the key symbol are visible. The key symbol is not represented in the figure.

The key body 5 is e.g. a plastic part produced by moulding. The body part is diffusively transparent. This implies that when the light travels through the material, the light beam scatters into various directions and this results in the illumination of the whole part.

Below the key 1 on the circuit board, at a distance from the light source, there is further arranged a photoelectric member 6, which can be e.g. a surface mounted phototransistor. The purpose of the photoelectric member 6 is to receive light coming from the light source through the body part 5.

A light barrier 7 is further arranged in connection with the circuit board 2 or with the key 1, the barrier being arranged to shield the photoelectric member 6 from the light of the light source 3 arriving from the body part 5. When the light path from the body part 5 to the photoelectric member 6 is hidden, the amount of light received by the photoelectric member 6 decreases and causes a change in the output of the photoelectric member 6. This change is used to indicate a depression of the key 1. The indication may be realized in many ways using known transistor circuits.

Above the light source 3, between the key cap 4 and the body part 5, there is arranged a reflecting surface 8 reflecting light from the light source 3 into the body part 5. This reflecting surface 8 is e.g. a mirror surface aluminized on the inclined hem of the key cap or on the inclined top edge of the body part 5. The reflecting surface 8 is intended to direct the light coming from the light source under the reflecting surface in the most effective way possible into the body part 5.

The key 1 shown in figure 1 has two reflecting surfaces 8a and 8b. Of these the reflecting surface 8a reflects the light at a substantially 90° angle from the light source 3 into the body part 5, and the reflecting surface 8b reflects the light at a substantially 90° angle downwards to the photoelectric member 6.

In this case shown in figure 1, the light barrier 7 is formed by a substantially vertical plane wall attached to the circuit board, the wall being located between the body part 5 and the second reflecting surface 8b, when the key 1 is in its depressed position.

When the key 1 is up according to figure 1a, the light path of the light source 3 extends from the light source 3 into the body part 5, being further reflected by the reflecting surface 8b downwards to the photoelectric member 6. When the key 1 is in its depressed position in accordance with figure 1b, the light barrier 7 hides the light path between the body part 5 and the reflecting surface 8b.

In the case of figure 2 the light barrier 7 is formed by a non-transparent shading surface fastened to the lower edge of the body part 5 above the photoelectric member 6. The shading surface could be an area provided with some coating not transparent to light.

In the embodiment shown in figure 2, there is formed on the lower edge of the body part 5, above the photoelectric member 6, a hollow 9 preferably in the form of a spherical calotte, so that the photoelectric member 6 is surrounded by the hollow 9 when the key 1 is in its depressed position. The surface of the hollow is non-transparent and forms the above mentioned shading surface.

When the key 1 is in its upper position according to figure 2, the light path from of the light source 3 extends from the light source 3 into the body part 5, being reflected by the reflecting surface 8 back into the body part, which will be illuminated and which at the same time illuminates the photoelectric member 6. When the key 1 is in its depressed position according to figure 2b, the light barrier 7 hides the light path between the body part 5 and the photoelectric member 6.

In the keyboard solution according to the invention it is favorable to use pulsed light. This presents the advantage, that static light, as e.g. daylight, will not interfere with the function of the key. Thus the photoelectric member 6 is arranged to receive intermittent light transmitted by the light source 3. The frequency is thus chosen to be sufficiently high, so that their will not be any substantial changes in the key illumination that can be perceived by the eye.

The invention is not limited to the embodiments described above, but it can be modified within the scope of the enclosed claims.

## Claims

1. A keyboard comprising at least one key (1) mounted in connection with a circuit board (2) including a light source (3), the key (1) comprising a key cap (4) and,between the key cap (4) and the circuit board (2), a body part (5) diffusively transmitting light from the light source for illuminating the key (1), the light source (3) being arranged to conduct said light into the body part (5) and to illuminate the key (1), wherein a photoelectric member (6) is mounted on the circuit board (2) under the key (1) at a distance from the light source (3), and wherein there is further arranged a light barrier (7) in connection with the circuit board (2) or with the key (1), the barrier being arranged to shield the photoelectric member (6) from the light of the light source (3) coming from the body part (5) when the key is in its depressed position and to produce an electric change in the photoelectric member (6) indicating the depression of the key.

2. A keyboard according to claim 1, **characterized** in that the light source (3) is placed on the circuit board (2) under the key, and that a reflecting surface (8) is arranged above the light source (3), between the key cap (4) and the body part (5), reflecting light from the light source (3) into the body part (5).

3. A keyboard according to claim 2, **characterized** in that the reflecting surface (8) comprises a first reflecting surface (8a) arranged at a first edge of the body part to reflect the light of the light source (3) at a substantially 90° angle into the body part (5) and a second reflecting surface (8b) arranged at a second edge opposite the first edge of the body part to reflect light from the body part (5) at a substantially 90° angle downwards to the photoelectric member (6), and that the light barrier (7) is formed by a substantially vertical plane wall attached to the circuit board (2), the wall being arranged to be located between the body part (5) and the second reflecting surface (8b), when the key (1) is in its depressed position.

4. A keyboard according to claim 2, **characterized** in that the light barrier (7) is formed by a non-transparent shading surface fastened to a lower edge of the body part (5) above the photoelectric member (6), the shading surface being arranged to be located immediately above the photoelectric member (6) and to hide it from light arriving from the body part (5) when the key is in its depressed position.

5. A keyboard according to claim 4, **characterized** in that there is formed on the lower edge of the body part (5), above the photoelectric member (6), a hollow (9) preferably in the form of a spherical calotte, so that the photoelectric member (6) is surrounded by the hollow (9) when the key (1) is in its depressed position, and that the surface of the hollow (9) forms the above mentioned shading surface.

6. A keyboard according to any claim 1 - 5, **characterized** in that the light source (3) is arranged to transmit light with a light quantity varying intermittently, e.g. pulsed light.

7. A keyboard according to any claim 1 - 5, **characterized** in that a light emitting diode functions as the light source (3).

8. A keyboard according to any claim 1 - 5, **characterized** in that a phototransistor functions as the photoelectric member (6).

## Patentansprüche

1. Tastatur mit mindestens einer Taste (1), die in Verbindung mit einer eine Lichtquelle (3) enthaltenden Leiterplatte (2) montiert ist und eine Tastenkappe (4) und einen Körperteil (5) zwischen der Tastenkappe (4) und der Leiterplatte (2) aufweist, der Licht von der Lichtquelle zum Beleuchten der Taste (1) diffus durchläßt, wobei die Lichtquelle (3) so ausgebildet ist, daß sie das Licht in den Körperteil (5) leitet und die Taste (1) beleuchtet, wobei ein photoelektrisches Element (6) auf der Leiterplatte (2) unter der Taste (1) von der Lichtquelle (3) beabstandet montiert ist, und wobei ferner eine Lichtblende (7) in Verbindung mit der Leiterplatte (2) oder der Taste (1) so angeordnet ist, daß sie das photoelektrische Element (6) gegen das vom Körperteil (5) herkommende Licht der Lichtquelle (3) abschirmt, wenn sich die Taste in ihrer niedergedrückten Stellung befindet, und sie eine elektrische Änderung im photoelektrischen Element (6) erzeugt, die das Niederdrücken der Taste anzeigt.

2. Tastatur nach Anspruch 1, **dadurch gekennzeichnet, daß** die Lichtquelle (3) auf der Leiterplatte (2) unter der Taste angeordnet ist und daß eine reflektierende Fläche (8) über der Lichtquelle (3) zwischen der Tastenkappe (4) und dem Körperteil (5) angeordnet ist, die Licht von der Lichtquelle (3) in den Körperteil (5) reflektiert.

3. Tastatur nach Anspruch 2, **dadurch gekennzeichnet, daß** die reflektierende Fläche (8) eine erste reflektierende Fläche (8a), die an einer ersten Kante des Körperteils angeordnet ist, um das Licht der Lichtquelle (3) unter im wesentlichen 90° in den Körperteil (5) zu reflektieren, und eine zweite reflektierende Fläche (8b) aufweist, die an einer zweiten, der ersten Kante des Körperteils gegenüberliegenden Kante angeordnet ist, um Licht vom Körperteil (5) unter im wesentlichen 90° nach unten zum photoelektrischen Element (6) zu reflektieren, und daß die Lichtblende (7) durch eine im wesentlichen vertikale, ebene Wand gebildet ist, die an der Leiterplatte (2) befestigt ist und so ausgebildet ist, daß sie zwischen dem Körperteil (5) und der zweiten reflektierenden Fläche (8b) liegt, wenn sich die Taste (1) in ihrer niedergedrückten Stellung befindet.

4. Tastatur nach Anspruch 2, **dadurch gekennzeichnet, daß** die Lichtblende (7) aus einer nicht-transparenten, abschirmenden Fläche besteht, die an der Unterkante des Körperteils (5) über dem photoelektrischen Element (6) befestigt ist und die so ausgebildet ist, daß sie unmittelbar über dem photoelektrischen Element (6) liegt und dieses gegen vom Körperteil (5) herkommendes Licht abschirmt, wenn sich die Taste in ihrer niedergedrückten Stellung befindet.

5. Tastatur nach Anspruch 4, **dadurch gekennzeichnet, daß** an der Unterkante des Körperteils (5) über dem photoelektrischen Element (6) ein Hohlraum (9), vorzugsweise in der Form einer kugelförmigen Kuppel, so ausgebildet ist, daß das photoelektrische Element (6) vom Hohlraum (9) umgeben wird, wenn sich die Taste (1) in ihrer niedergedrückten Stellung befindet, und daß die Oberfläche des Hohlraums (9) die oben genannte Abschirmungsfläche bildet.

6. Tastatur nach einem der Ansprüche 1 - 5, **dadurch gekennzeichnet, daß** die Lichtquelle (3) so ausgebildet ist, daß sie Licht mit intermittierender Lichtmenge, d.h. gepulstes Licht, aussendet.

7. Tastatur nach einem der Ansprüche 1 - 5, **dadurch gekennzeichnet, daß** eine lichtemittierende Diode als Lichtquelle (3) dient.

8. Tastatur nach einem der Ansprüche 1 - 5, **dadurch gekennzeichnet, daß** ein Phototransistor als photoelektrisches Element (6) dient.

## Revendications

1. Clavier comprenant au moins une touche (1) montée en connexion avec une plaque de circuits (2) comportant une source lumineuse (3), la touche (1) comportant une tête de touche (4) et, entre la tête de touche (4) et la plaque de circuits (2), une pièce de corps (5) transmettant de façon diffuse la lumière de la source lumineuse pour éclairer la touche (1), la source lumineuse (3) étant disposée pour diriger ladite lumière dans la pièce de corps (5) et pour éclairer la touche (1), clavier dans lequel un élément photoélectrique (6) est monté sur la plaque de circuits (2) sous la touche (1) à distance de la source lumineuse (3), et dans lequel est de plus disposée une barrière de lumière (7) en connexion avec la plaque de circuits (2) ou avec la touche (1), la barrière de lumière étant disposée pour protéger l'élément photoélectrique (6) de la lumière de la source lumineuse (3) provenant de la pièce de corps (5) lorsque la touche est en position enfoncée et pour produire un changement électrique dans l'élément photoélectrique (6) indiquant l'enfoncement de la touche.

2. Clavier selon la revendication 1, caractérisé en ce que la source lumineuse (3) est placée sur la plaque de circuits (2) sous la touche, et qu'une surface réfléchissante (8) est disposée au dessus de la source lumineuse (3), entre la tête de touche (4) et la pièce de corps (5), réfléchissant la lumière de la source lumineuse (3) dans la pièce de corps (5).

3. Clavier selon la revendication 2, caractérisé en ce que la surface réfléchissante (8) comprend une première surface réfléchissante (8a) disposée à un premièr bord de la pièce de corps pour réfléchir la lumière de la source lumineuse (3) à un angle d'environ 90° dans la pièce de corps (5) et une seconde surface réfléchissante (8b) disposée à un second bord opposé au premier bord de la pièce de corps pour réfléchir la lumière de la pièce de corps (5) à un angle d'environ 90° vers le bas en direction de l'élément photoélectrique (6), et que la barrière de lumière (7) est formée par une paroi plane substantiellement verticale fixée à la plaque de circuits (2), la paroi étant disposée pour être située entre la pièce de corps (5) et la seconde surface réfléchissante (8b), lorsque la touche (1) est en position enfoncée.

4. Clavier selon la revendication 2, caractérisé en ce que la barrière de lumière (7) est constituée par une surface d'obstruction non-transparente fixée au bord le plus bas de la pièce de corps (5) sous l'élément photoélectrique (6), la surface d'obstruction étant disposée pour être située immédiatement au dessus de l'élément photoélectrique (6) et le cacher de la lumière arrivant de la pièce de corps (5) lorsque la touche est en position enfoncée.

5. Clavier selon la revendication 4, caractérisé en ce qu'un évidement (9) de préférence en forme de calotte sphérique, est formé sur le bord le plus bas de la pièce de corps (5), au dessus de l'élément photoélectrique (6), afin que l'élément photoélectrique (6) soit entouré par l'évidement (9) lorsque la touche (1) est en position enfoncée, et que la surface de l'évidement (9) forme la surface d'obstruction mentionnée ci-dessus.

6. Clavier selon l'une quelconque des revendications 1 à 5, caractérisé en ce que la source lumineuse (3) est disposée pour transmettre la lumière en une quantité variable par intermittence, par exemple une lumière par impulsions.

7. Clavier selon l'une quelconque des revendications 1 à 5, caractérisé en ce qu'une diode émettrice de lumière fait office de source lumineuse (3).

8. Clavier selon l'une quelconque des revendications 1 à 5, caractérisé en ce que le phototransistor fait office d'élément photoélectrique (6).
